# EUROPEAN PATENT SPECIFICATION

(11) **EP 0 804 628 B1**
(45) Date of publication and mention of the grant of the patent: **04.11.1998**
(21) Application number: 95930779.4
(22) Date of filing: 01.09.1995
(51) Int. Cl.: C22C 45/00, C22F 1/00, H01F 1/153, H01L 41/12

(54) **METHOD OF MANUFACTURE OF AMORPHOUS TRANSDUCER ELEMENTS**
HERSTELLUNGSVERFAHREN FÜR AMORPHES TRANSDUKTORELEMENT
PROCEDE DE PRODUCTION D'ELEMENTS TRANSDUCTEURS AMORPHES

(30) Priority: 02.09.1994 SE 9402945
(43) Date of publication of application: 05.11.1997
(73) Proprietor: RSO CORPORATION N.V., Curaçao (AN)
(72) Inventor: WUN-FOGLE, Marilyn, Gaitherburg, MD 20878 (US); LUU, Thu-Van, T., Riverdale, MD 20737 (US); CLARK, Arthur, E., Adelphi, MD 20783 (US); TYR N, Carl, F-06600 Antibes (FR)
(74) Representative: Ström, Tore
(86) International application number: SE9500984
(87) International publication number: WO9607767

(56) References cited:
- EP-A- 0 318 875
- DE-A- 1 533 487
- DE-A- 2 709 626
- DE-B- 1 154 277
- DE-C- 3 705 893
- IEEE TRANSCTIONS ON MAGNETICS , vol.MAG-17, no.6, NOV. 1981, page 2837 - 2839, MODZELEWSKI ET AL 'MAGNETOMECHANICAL COUPLING AND PERMEABILITY IN TRAVERSELY ANNEALED METGLAS 2605 ALLOY'
- PATENT ABSTRACTS OF JAPAN, Vol. 11, No. 3, C-395; & JP,A,61 183 453 (TOSHIBA CORP), 16 August 1986.
- PATENT ABSTRACTS OF JAPAN, Vol. 12, No. 283, C-518; & JP,A,63 060 264 (TOHOKU METAL IND LTD), 16 March 1988.

## Description

The present invention relates to a method for manufacturing amorphous transducer elements with a high magnetomechanical coupling and with various non-planar cross-sectional shapes.

A well known fact is that amorphous magnetic strips, such as ribbons, wires, etc., can be made into transducer elements with a high magnetomechanical coupling by heat-treating or annealing the strip or the ribbon in a transverse magnetic field. For instance, see IEEE Transactions on Magnetics, Vol. MAG-17, NO. 6 , November 1981: "Magnetomechanical Coupling and Permeability in Transversely Annealed Metglas 2605 Alloys". The accepted procedure is to place the un-annealed strip in a vacuum or argon-filled furnace and anneal the strip at a temperature of 380°C to 430°C. In this temperature range an atomic motion occurs, but the material maintains its non-crystalline structure. During the annealing process a magnetic field is applied, which is sufficiently strong to develop magnetic domains, and the axes of which are perpendicular to the strip.

A difficulty arises when it is desired to give the magnetic strip a particular cross-sectional shape and at the same time achieve a high magnetomechanical coupling. The ideal design is a thin ribbon with an arched cross-sectional shape.

If the ribbon for this purpose is placed in a two-part fixture forming the strip to the desired shape, the fixture inevitably generates undesired forces in portions of the strip, generally along the edges. The stresses caused by the fixture unfortunately prevents the development of domain configurations with a high coupling factor during the annealing process. The result is a substantially reduced coupling factor.

Until now, the difficulties described above have limited amorphous magnetoelastical strips or ribbons to planar thin strips or ribbons, which due to their flexibility and lack of stiffness have caused difficulties when the strips are being used in certain applications.

According to the present invention a method is provided that renders it possible to manufacture amorphous magnetic strips or ribbons with any desired non-planar cross-sectional shape, while achieving a high magnetomechanical coupling.

In the method according to the invention the strip annealing process is divided into two steps, fixture tension being released between the two steps.

An application of the method according to the invention, which has proved successful, comprises the following steps:
a) The strip or ribbon is arranged in a two-part fixture adapted to give the strip the desired cross-sectional shape, the fixture then being closed and the strip, firmly fixed inside the fixture, being exposed to an annealing process at a temperature of around 360°C, without influence from any magnetic field during the annealing process.
b) After the annealing process has been completed according to step a), the fixture and the strip are cooled.
c) After the cooling the upper part of the fixture is removed, and the strip, now resting on the lower part of the fixture, is exposed to a second annealing process in the temperature range between 380°C and 430°C, a transverse magnetic field sufficiently strong to develop a domain structure with a high coupling factor being applied in a manner known per se during the annealing process.

The resulting product is a transducer element with a high magnetic coupling and with the desired shape.

## Claims

1. Method for manufacturing amorphous transducer elements with a high magnetomechanical coupling and with various cross-sectional shapes, **1, characterized** in that the amorphous strip or ribbon is arranged in a shaping fixture and is annealed in a two-step process with an intermediate cooling step, the annealing process of the first step being carried out with the strip or ribbon firmly fixed in the fixture but with no influence from any magnetic field, and the annealing process of the second step being carried out at a higher temperature with the strip or ribbon no longer being fixed in the fixture and under the influence of a transverse magnetic field.

2. Method according to claim **1, characterized** in
a) that the strip or ribbon is put into a two-part fixture adapted to give the strip or ribbon a desired cross-sectional shape, the fixture then being closed and the strip, firmly fixed inside the fixture, being exposed to an annealing process at a temperature of approximately 360°C,
b) that the fixture and the strip are cooled down after the annealing process of a) having been completed, and
c) that after the cooling, the upper part of the fixture is removed, and the strip or ribbon, now resting upon the lower part of the fixture, is exposed to a second annealing process in a temperature range between 380°C and 430°C, a transverse magnetic field sufficiently strong to develop a domain structure with a high coupling factor being applied in a manner known per se during the annealing process.

## Patentansprüche

1. Verfahren zum Herstellen amorpher Wandlerelemente mit hoher magnetomechanischer Kopplung und mit verschiedenen Querschnittsformen, **dadurch gekennzeichnet**, daß der amorphe Streifen oder das amorphe Band in einer Formungsbefestigung angeordnet wird und in einem zweistufigen Prozeß mit einem Zwischenkühlungsschritt geglüht wird, wobei der Glühprozeß des ersten Schrittes bei in der Befestigung befestigtem Streifen oder Band, jedoch ohne Einfluß irgendeines Magnetfeldes, ausgeführt wird und der Glühprozeß des zweiten Schrittes bei einer höheren Temperatur bei nicht mehr in der Befestigung befestigtem Streifen oder Band und unter dem Einfluß eines transversalen Magnetfeldes ausgeführt wird.

2. Verfahren nach Anspruch 1, **dadurch gekennzeichnet,** daß
a) der Streifen oder das Band in eine zweiteilige Befestigung eingesetzt wird, die so beschaffen ist, daß sie dem Streifen oder dem Band eine gewünschte Querschnittsform verleiht, wobei die Befestigung anschließend geschlossen wird und der Streifen, der in der Befestigung befestigt ist, einem Glühprozeß bei einer Temperatur von ungefähr 360 °C ausgesetzt wird,
b) die Befestigung und der Streifen nach Abschluß des Glühprozesses von a) abgekühlt werden und
c) nach der Kühlung der obere Teil der Befestigung abgenommen wird und der Streifen oder das Band, das nun auf dem unteren Teil der Befestigung liegt, einem zweiten Glühprozeß in einem Temperaturbereich zwischen 380 °C und 430 °C ausgesetzt wird, wobei ein transversales Magnetfeld, das ausreichend stark ist, um eine Bereichsstruktur mit einem hohen Kopplungsfaktor zu entwickeln, in an sich bekannter Weise während des Glühprozesses angelegt wird.

## Revendications

1. Procédé de fabrication d'éléments transducteurs amorphes, ayant un couplage magnéto-mécanique élevé et différentes formes de sections transversales, caractérisé en ce que la bande ou ruban amorphe est agencé(e) dans une fixation de formage et est soumis(e) à un recuit dans un procédé à deux étapes ayant une étape de refroidissement intermédiaire, le procédé de recuit de la première étape étant exécuté avec la bande ou ruban fixé rigidement dans la fixation, mais sans aucun effet de champ magnétique quelconque, et le procédé de recuit de la deuxième étape étant exécuté à une température plus élevée avec la bande ou ruban qui n'est plus fixé dans la fixation et sous l'effet d'un champ magnétique transversal.

2. Procédé selon la revendication 1, caractérisé en ce que
a) la bande ou ruban est placé dans une fixation en deux parties, adaptée pour fournir à la bande ou ruban une forme de section transversale souhaitée, la fixation étant ensuite fermée et la bande, fixée rigidement dans la fixation, étant exposée à un procédé de recuit à une température d'environ 360°C,
b) la fixation et la bande sont refroidies après que le procédé de recuit de a) ait été achevé, et
c) après le refroidissement, la partie supérieure de la fixation est retirée, et la bande ou ruban, reposant maintenant sur la partie inférieure de la fixation, est exposé(e) à un deuxième procédé de recuit dans une plage de températures comprise entre 380°C et 430°C, un champ magnétique transversal, suffisamment puissant pour développer une structure de domaines ayant un facteur de couplage élevé, étant appliqué de manière connue en soi durant le procédé de recuit.
